# EUROPEAN PATENT SPECIFICATION

(11) **EP 0 348 626 B1**
(45) Date of publication and mention of the grant of the patent: **05.08.1998**
(21) Application number: 89107212.6
(22) Date of filing: 21.04.1989
(51) Int. Cl.: H01L 21/82, H01L 27/06

(54) **Process for fabricating isolated vertical bipolar and JFET transistors and corresponding IC**
Verfahren zur Herstellung von isolierten vertikalbipolaren und JFET-Transistoren und entsprechender IC
Procédé pour l'intégration de transistors isolés bipolaires verticaux et JFET et circuit intégré correspondant

(30) Priority: 27.06.1988 US 211641
(43) Date of publication of application: 03.01.1990
(60) Divisional application: 94112898.5
(73) Proprietor: TEXAS INSTRUMENTS INCORPORATED, Dallas Texas 75265 (US)
(72) Inventor: Seacrist, Michael R., Grapevine Texas 76051 (US); Trogolo, Joe R., Plano Texas 75023 (US); Bell, Kenneth M., Windom Texas 75492 (US)
(74) Representative: Leiser, Gottfried, Dipl.-Ing.

(56) References cited:
- EP-A- 0 006 119
- FR-A- 1 559 609
- ELEKTRONIK, vol. 26, no. 11, November 1977, page 22; "La technologie BIFET"
- ELECTRONICS, vol. 61, no. 17, November 1988, pages 125,128, Hasbrook Heights, NJ, US; S. WEBER: "TI's new linear process powers an advanced family of OP amps"

## Description

### TECHNICAL FIELD OF THE INVENTION

This invention relates in general to the fabrication of different integrated circuit devices using a single semiconductor substrate, and more particularly to a process for simultaneously fabricating a vertical bipolar transistor and a junction field effect transistor (JFET) and the integrated circuit produced thereby.

From EP-A-0 006 119 a process is known for the formation of an NPN transistor on a P-type substrate merged with a JFET. The devices are formed in an epitaxial layer. Elektronik vol. 26, no. 11, November 1977, page 22 discloses a similar process in which a JFET and NPN transistor are formed on a p-type substrate with an n-type epitaxial layer. FR-A-1 559 609 discloses a process for prducing a PNP transistor and an FET with an n-type channel on a p-type substrate.

### BACKGROUND OF THE INVENTION

Operational amplifier designs have always been limited in that conventional PNP integrated circuit transistors used therefor can operate only to around 5 megahertz. These PNP transistors in combination with conventional NPN transistors are typical devices found in operational amplifier integrated circuits.

Recently, a high-frequency isolated vertical PNP (VPNP) transistor has been developed that is superior to the conventional and substrate PNP transistors. This isolated VPNP transistor is capable of 45-volt operation and exhibits a maximum operating frequency around 150 megahertz. The current gain and breakdown voltages on the isolated VPNP transistor are comparable to those achieved on the standard double diffused NPN transistor. Finally, the isolated VPNP is not limited to the emitter-follower configuration taken by the normal vertical substrate PNP transistor.

Separately, a 50-volt (p) channel JFET has been developed to extend the gate-to-drain breakdown voltage past 45 volts. JFETs of this kind are conventionally used as operational amplifier inputs. These JFETs are achieved by using a thick deposited oxide over the gate oxide to reduce the electric field intensification at the top gate/drain reverse-biased p-n junction. This increases the gate-to-drain breakdown voltage from the low 30 volt range to approximately 50 volts. The gate-to-drain and gate-to-source oxides overlap capacitances are also reduced with the deposited oxide. This contributes to higher bandwidths and slew rates.

Another desirable integrated circuit component is the metal/nitride/poly capacitor. The use of nitride in the place of oxide provides a doubling of the capacitance and allows for a dielectric breakdown in excess of 100 volts, and the fabrication of these capacitors on field oxide reduces parasitic junction capacitance and tank leakage currents.

It is therefore desirable to develop a process for the fabrication of an integrated circuit including each of these devices. As yet, no such process has been heretofore developed, limiting circuit designers to the use of one of these circuit devices without the others in any one integrated circuit.

### SUMMARY OF THE INVENTION

One aspect of the present invention comprises a process for the simultaneous fabrication of a vertical bipolar transistor and a junction field effect transistor (JFET) using a single semiconductor substrate. According to this process, a JFET buried region of a second conductivity type is formed at a face of the semiconductor substrate. A bipolar buried region of the second conductivity type is next formed at the face so as to be spaced from the JFET buried region. A collector region of the first conductivity type is formed at the face of the semiconductor substrate and within the bipolar buried region. Thereafter, an epitaxial semiconductor layer of the second conductivity type is formed on the face of the semiconductor substrate.

A thermal diffusion step is next performed to extend the JFET buried region and the bipolar collector region into the epitaxial layer. Then, a deep collector region of the first conductivity type is formed to extend from an outer face of the epitaxial layer to the collector region. A base region of the first conductivity type is formed at the face of the epitaxial layer over the collector region so as to be spaced therefrom. Next, an emitter region, a JFET source region and a JFET drain region are simultaneously formed to be of the first conductivity type and at the face of the epitaxial layer. The emitter region is formed within the base region, while the source and drain regions of the JFET are formed over and spaced from the JFET buried region. Thereafter, a base contact region for the bipolar transistor and a gate contact region for the JFET are simultaneously formed to be of the second conductivity type at the face of the epitaxial layer. The base contact region is formed within the base region and spaced from the emitter region, while the gate contact region is formed over the JFET buried region and spaced from the source and drain regions.

A further deep junction isolation region of the first conductivity type is formed at the same time as at least one other deep junction isolation region used to electrically separate the fabricated devices.

Dopant from these deep junction isolation regions are simultaneously up-diffused into the epitaxial layer. At least two shallow junction isolation regions of the first conductivity type are formed in the epitaxial layer. Dopant from the shallow junction isolation regions is down-diffused such that the deep and shallow junction isolation regions form continuous junction isolation regions.

During subsequent diffusion steps, a thick layer of field oxide is formed over the junction isolation region over which the capacitor will be built. A polysilicon layer is deposited, patterned and etched on top of the field oxide layer, and is preferably doped simultaneously with the formation of the JFET gate contact region.

The incorporation of the fabrication steps of these devices into a single process flow has the advantage of greatly reducing the number of mask levels required for the separate fabrication of each. An integrated circuit containing these three devices gives integrated circuit designers much more leeway and flexibility than the more conventional devices that they supplement. The combination of the VPNP transistor, the 50-volt (p) channel JFET, the metal/nitride/polysilicon capacitor, and double-diffused junction isolation, as used on a substrate of (100) crystallographic orientation, achieves tight input offset voltage control. These enhancements combine to provide circuit designs with the opportunity to design high performance control circuits capable of 5x bandwidth improvement, fast settling times (200 nanoseconds), precise input offset voltage control (+/- 100 microvolts), and other key design enhancements. The process is compatible with more conventional 45 volt vertical NPN transistors, high sheet resistors, 45 volt threshold voltages, and other common features of linear bipolar/JFET fabrication processes. The double (up and down) diffused isolation preferably used in the construction of the devices of the invention allows for a tighter design layout and can save up to 25% layout area on spacing relative to single-diffusion isolation.

### BRIEF DESCRIPTION OF THE DRAWINGS

Other aspects of the invention and their advantages will become apparent by referring to the following detailed description in conjunction with the drawings in which:
FIGURES 1-4 are greatly enlarged schematic sections showing successive stages of fabricating a vertical PNP transistor, a p-channel JFET and a vertical NPN transistor according to the invention;
FIGURE 3a is a detail of the sectional view shown in FIGURE 3, showing additional JFET fabrication steps; and
FIGURE 5 is a greatly enlarged schematic sectional view of a metal/nitride/polysilicon capacitor that can be fabricated in conjunction with the devices shown in FIGURES 1-4.

### DETAILED DESCRIPTION OF THE INVENTION

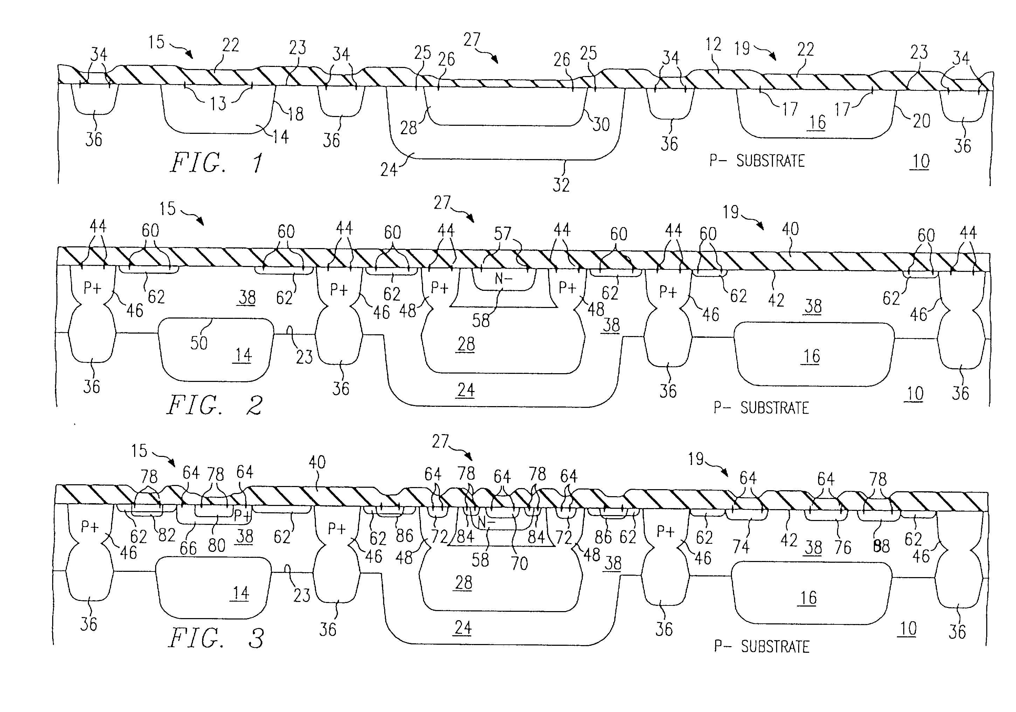

Referring first to FIGURE 1, a (p-) silicon substrate 10 is shown in a greatly enlarged and schematic view. Silicon substrate 10 may have either (100) or (111) crystallographic orientation, although (100) orientation is preferred. An initial oxide layer 12, here shown after several patternings, etches and regrowths of replacement oxide, is grown on substrate 10. After this, a portion of oxide layer 12 between limits 13 (schematically shown by hash marks) is removed using conventional pattern-and-etch techniques to create a mask for the implantation of an (n+) buried collector region 14 for an NPN vertical transistor in an NPN bipolar transistor area indicated generally at 15. At the same time, an (n+) buried region 16 is masked in oxide layer 12 to limits 17 in a (p) channel JFET area of the substrate indicated generally at 19. The sheet resistance of the buried collector region 14 and JFET buried region 16 should be approximately 15 Ohms/square, and a preferred dopant is antimony.

After the implantation of the dopant, substrate 10 is subjected to a thermal diffusion step to give the respective approximate conductivity type boundaries 18 and 20 of the buried regions 14 and 16 as shown. During this and subsequent thermal diffusion steps, oxide portions, such as portions 22, will grow back wherever the outer surface 23 of the silicon substrate 10 has been exposed before the previous implantation step.

Next, oxide layer 12 is removed within limits 25 and an (n-) buried region 24 is implanted and thermally diffused within a vertical PNP transistor area indicated generally at 27. The dopant concentration used to implant buried region 24 is much less than that of collector region 14 and JFET buried region 16, as using the same dopant level would overwhelm the vertical PNP collector region subsequently formed and described immediately below.

In a similar manner, the oxide layer 12 is again removed within limits 26 to mask an implantation step for forming a (p) vertical PNP transistor collector region 28. A preferred implanted dopant species is boron. The (p) dopant is diffused by means of a thermal cycle such that the approximate final limit between (p) type and (n) type material is marked by boundary 30. The distance between boundary 30 of VPNP transistor collector region 28 and the boundary 32 of buried region 24 must be sufficient to isolate collector region 28 from the (p-) substrate 10, and to withstand more than the maximum operating voltage potential and not have a punch-through voltage breakdown.

Simultaneously with the removal of oxide from layer 12 within limits 26, oxide is removed within limits 34 such that the (p) type dopant implanted into region 28 will also be implanted into a plurality of deep junction isolation regions 36. Regions 36 are provided to isolate the devices from each other such that parasitic transistor devices will not be formed.

Turning now to FIGURE 2, oxide layer 12 is stripped and an (n-) epitaxial silicon layer 38 is grown on the surface 23 of semiconductor substrate 10. A second oxide layer 40 is grown from an outer surface 42 of epitaxial layer 38.

Oxide layer 40 is next removed within limits 44 to provide a mask for the next implantation step, which is a heavy deposition of (p) type dopant. The (p) dopant is diffused in a subsequent thermal cycle to create shallow (p+) junction isolation regions 46 and a (p+) deep collector region 48. Each shallow isolation region 46 overlies a respective deep isolation region 36, and region 48 overlies VPNP buried collector region 28. Deep collector region 48 is preferably annular or otherwise endless.

The deposition of the (p) dopant is followed by a thermal diffusion drive-in step such that shallow junction isolation regions 46 become continuous with deep junction isolation regions 36, and such that deep collector region 48 will become continuous with buried collector region 28. In this diffusion step, dopant diffuses upwardly from semiconductor substrate 10 at the same time that dopant diffuses downwardly from the surface of epitaxial layer 38. This up-diffusion establishes upper boundaries 50 of collector regions 14 and 16 and upper boundary 52 of VPNP collector region 28.

In the various diffusion steps conducted, it is important to balance the thermal cycles in order to get the proper amount of diffusion. Hence, earlier-created structures should be subjected to a less severe thermal cycle than later-created structures if all other parameters are the same, because the later thermal cycles will affect the extent and concentrations of earlier created structures as well as the later ones.

Next, oxide layer 40 is removed within limits 57 and an (n) type dopant is implanted therein to form an (n-) base region 58 for the VPNP transistor. Subsequently, oxide layer 40 is removed within limits 60 to permit the implantation of an (n) type dopant such as antimony. After this implantation, a thermal diffusion drive-in step is conducted on epitaxial layer 38 such that the (n) type dopant implanted between limits 57 and between limits 60 diffuses to create threshold adjust regions 62 and to set VPNP base region 58. Threshold adjust regions 62 are desirable to prevent parasitic PMOS transistors between (p) diffusions, such as diffused regions 46 and 48. Threshold adjust regions 62 control the junction breakdown voltage such that it can exceed the standard 45-volt operating voltage.

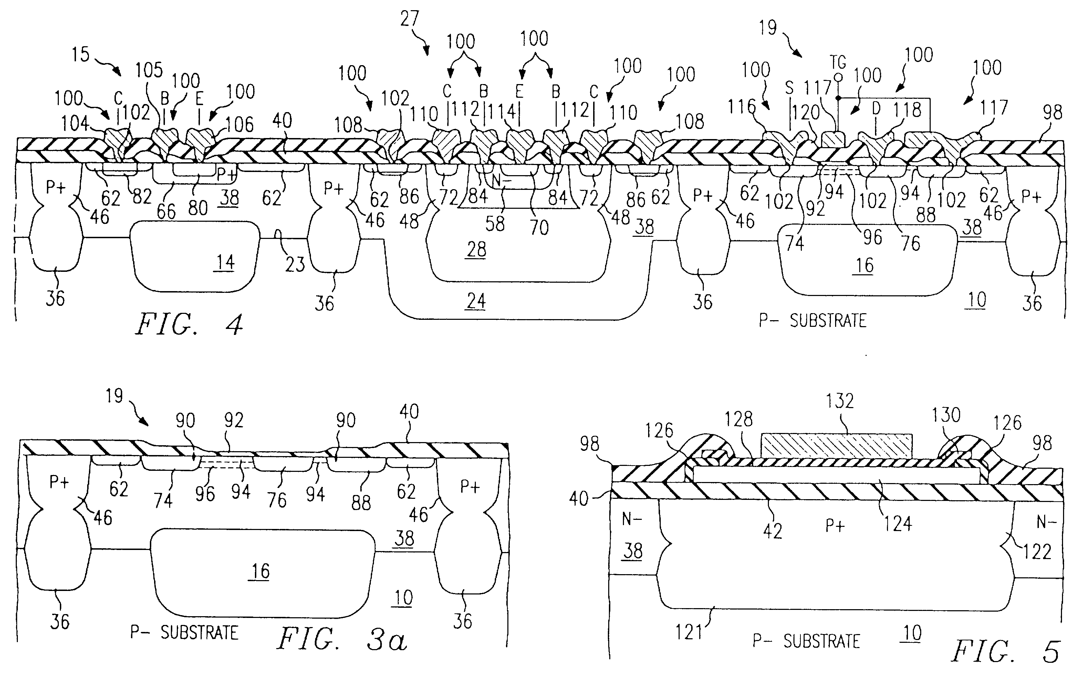

Turning now to FIGURE 3, a portion of oxide layer 40 is removed within limits 64 in NPN transistor area 15, VPNP transistor area 27, and JFET area 19. Then, a (p) type dopant is deposited and thermally diffused to create a (p⁺) NPN transistor base region 66, a VPNP transistor (p⁺) emitter region 70, an annular or endless (p⁺) contact region 72 inside VPNP deep collector region 48, a (p⁺) JFET source region 74 and a (p⁺) JFET drain region 76. After this step, high sheet resistance resistors (not shown) may be patterned by removal of certain portions of oxide layer 40 (not shown) with a subsequent oxidation and implantation to create the resistors (not shown) in layer 38.

Next, oxide is removed from oxide layer 40 down to the surface 42 of the epitaxial layer 38 within limits 78 in all three device areas 15, 19 and 27 for masking the deposition of an (n) type dopant. The dopant thus deposited is subsequently thermally diffused to create a conventional vertical NPN emitter region 80, a collector contact region 82 for the conventional NPN transistor, a vertical PNP base contact region 84, a buried region contact 86 for ohmic contact to buried region 24, and a JFET gate contact region 88. In the embodiment shown, base contact region 84 is annular or otherwise endless.

To illustrate further steps in the fabrication of the JFET, a sectional detailed view is shown in FIGURE 3a. Field oxide 40 is removed between limits 90 and a thin gate oxide 92 is grown over the exposed surface of epitaxial layer 38. An (n) type dopant, preferably phosphorus, is next implanted through gate oxide 92 to form a top gate region 94 that extends from gate contact region 88 to both source region 74 and drain region 76. After this implantation step, a layer of photoresist (not shown) is used to mask all areas of gate oxide 92 except a window extending from drain region 76 to source region 74. This remaining exposed area is subjected to a boron implantation step to create a JFET channel region 96 that extends from source region 74 to drain region 76.

The final steps of the preferred process are shown in FIGURE 4. The photoresist is stripped and a middle-level oxide layer 98 is deposited over the surface of oxide layer 40. Middle-level oxide layer 98 is then densified in a thermal step. A plurality of contact orifices 100 are next patterned and etched into middle-level oxide layer 98. The middle-level oxide layer 98 is then reflowed into the contact orifices 100 to produce sloping sidewalls thereof. A respective orifice 102 in field oxide layer 40 is opened below each contact orifice 100 to expose the surface 42 of the epitaxial layer 38 therebeneath. Metal leads 104-118 are then deposited, patterned and etched according to conventional methodology.

An important aspect of the invention is the existence of a middle level oxide portion 120 that is left over JFET channel 96. Top gate metal lead 117 is patterned and etched not only to contact gate contact region 88, but to extend over channel 96 spaced therefrom by middle level oxide portion 120. The existence of middle level oxide portion 120 allows the achievement of up to 45 volts in operating voltage. The standard (p) channel JFET without middle level oxide portion 120 would only operate up to a limit of approximately 32 to 33 volts because of problems associated with the electric field intensification at the drain/top gate junction. Middle level oxide portion 120 reduces the field intensification that occurs there, and allows the breakdown voltage to be extended out to as much as 50 volts. Middle level oxide portion 120 therefore allows the construction of a 45-volt chip. A passivating nitride layer (not shown) is preferably added thereafter to passivate the exposed surface of the completed integrated circuit.

FIGURE 5 is a greatly enlarged schematic cross sectional view of a capacitor that can be formed during the fabrication process of the other devices above described, with like numbers identifying like structure as appropriate. In a separate area of (p) type semiconductor substrate 10, a deep isolation junction region 121 is implanted with a (p) type dopant at the same time that buried collector region 28 and deep junction isolation regions 36 (FIGURE 1) are implanted. The epitaxial layer 38 is then grown on semiconductor substrate 10 and second oxide layer 40 is grown on epitaxial layer 38. An orifice (not shown) is next opened into oxide layer 40 and a (p) type dopant is deposited on the surface 42 of layer 38 at the same time that the (p) type deposition is performed for shallow junction isolation regions 46 and deep collector region 48 (FIGURE 2). Next, a thermal diffusion step is performed that up-diffuses dopant from region 121 and down-diffuses the dopant deposited on the surface 42 of epitaxial layer 38. This combined up-diffusion and down-diffusion creates a continuous junction isolation region 122 that extends from epitaxial surface 42 into semiconductor substrate 10.

Prior to the doping/diffusion sequence that creates NPN emitter region 80, VPNP base contact region 84 and JFET gate contact region 88 (FIGURE 3), a polycrystalline silicon layer is deposited, patterned with a photoresist mask, and etched to form a polysilicon electrode 124. Electrode 124 is rendered conductive by a heavy deposition of the (n) type dopant used to create emitter region 80, top gate contact region 88 and VPNP base contact region 84. The diffusion step by which the emitter dopant is diffused into regions 80, 84 and 88 will at the same time cause an oxide layer 126 to grow from the exposed surface of polysilicon electrode 124.

In summary, a unified process for the fabrication of a vertical PNP transistor, a (p) channel JFET transistor and a metal/nitride/polysilicon capacitor, as well as conventional vertical NPN transistors and other standard devices used in linear bipolar/JFET integrated circuits, has been shown and described. The unified process eliminates many masking steps and permits increased flexibility in circuit design.

## Claims

1. A process of fabricating a vertical bipolar transistor and a junction field effect transistor (JFET) using a single semiconductor substrate (10) of a first conductivity type, comprising the steps of:
forming a JFET buried region (16) of a second conductivity type at a face of the semiconductor substrate;
forming a bipolar buried region (24) of the second conductivity type at the face and spaced from the JFET buried region;
forming a collector region (28) of the first conductivity type at the face and within the bipolar buried region;
forming an epitaxial semiconductor layer (38) of the second conductivity type on the face of the semiconductor substrate;
extending the JFET buried region and the collector region into the epitaxial layer by thermal diffusion;
forming a deep collector region (48) of the first conductivity type to extend from an outer face of the epitaxial layer to the collector region;
forming a base region (58) of the first conductivity type at the face of the epitaxial layer over the collector region and spaced therefrom;
simultaneously forming an emitter region (70), a JFET source region (74) and a JFET drain region (76) of the first conductivity type at the face of the epitaxial layer, the emitter region formed within the base region, the JFET source and drain regions formed over and spaced from the JFET buried region and laterally spaced from each other; and simultaneously forming a base contact region (84) and a gate contact region (88) of the second conductivity type at the face of the epitaxial layer, the base contact region formed within the base region and spaced from the emitter region, the gate contact region formed over the JFET buried region and spaced from the source and drain regions.

2. The process of claim 1, wherein said first conductivity type is (p).

3. The process of claim 1 or claim 2 and further comprising the steps of:
forming at least one deep junction isolation region (36) to be of the first conductivity type in the semiconductor substrate at the same time as said step of forming the collector region therein, the deep junction isolation region formed in between the collector region and the JFET buried region; and
forming at least one shallow junction isolation region (46) of the first conductivity type in the epitaxial layer over the deep junction isolation region at the same time as said step of forming the deep collector region, such that the shallow junction isolation region and the deep junction isolation region are joined.

4. The process of claim 3, and further comprising the step of:
forming a field adjust region (62) with a dopant of the second conductivity type at the face of the epitaxial layer to be disposed between the base region and the shallow junction isolation region.

5. The process of claim 3 or claim 4, and further comprising the steps of:
simultaneously up-diffusing dopant from the deep junction isolation region and from the collector region into the epitaxial layer; and
simultaneously down-diffusing dopant from the shallow isolation junction region and from the deep collector region, such that the deep collector region makes contact with the collector region and such that the shallow and deep junction isolation regions become continuous.

6. The process of any one of claims 1 to 4, and further comprising the step of down-diffusing dopant from the deep collector region until the deep collector region becomes continuous with the collector region.

7. The process of any preceding claim, and further comprising the step of forming a first oxide layer (12) across an outer face of the semiconductor substrate; and
prior to each of said respective steps of forming the collector region, forming the bipolar buried region and forming the JFET buried region, removing for each said respective step a respective predetermined portion of the oxide layer so that the oxide layer acts as a doping mask for said respective step.

8. The process of any preceding claim, and further comprising the steps of:
after said step of forming the epitaxial semiconductor layer, forming an oxide layer (40) on an outer face of the epitaxial layer; and
prior to each of said respective steps of forming the deep collector region, forming the base region, and forming the emitter region, removing a respective portion of the oxide layer to act as a respective dopant mask for said respective step.

9. The process of any preceding claim, and further comprising the steps of:
after said step of simultaneously forming the base contact region and the gate contact region, forming a gate insulator layer (92) over the epitaxial layer over a channel region thereof between the source region and the drain region, and to laterally extend to the gate contact region;
implanting dopant of the second conductivity type through the gate insulator layer to form a top gate extending from the gate contact region to the source and drain regions; and
implanting dopant of the first conductivity type through the gate insulator layer to dope the channel region.

10. The process of any preceding claim, and further comprising the steps of:
forming a deep junction isolation region (121) of the first conductivity type in the substrate at the same time as said step of forming the collector region; and
forming a capacitor over the junction isolation region.

11. The process of claim 10, and further comprising the step of forming a shallow junction isolation region (46) of the first conductivity type in the epitaxial layer for the capacitor at the same time as said step of forming the deep collector region, such that the deep junction isolation region and the shallow junction isolation region will become a continuous junction isolation region.

12. The process of claim 11, and further comprising the steps of:
forming an oxide layer (40) on the epitaxial layer over the junction isolation region; and
forming a capacitor on the oxide layer over the junction isolation region.

13. The process of any preceding claim, wherein a capacitor is formed in a capacitor area of the semiconductor substrate, said process further including the steps of:
forming a polycrystalline silicon capacitor electrode (124) to be insulatively spaced over the epitaxial layer in the capacitor area; and doping the polycrystalline silicon electrode to be highly conductive at the same time as said step of simultaneously forming the base contact region and the gate contact region.

14. The process of any preceding claim, and further including the step of forming a bipolar buried region contact region (86) of the second conductivity type at the outer face of the epitaxial layer over the bipolar buried region and spaced from the deep collector region, at the same time as said step of simultaneously forming the base contact region and the gate contact region.

15. An integrated circuit including a vertical bipolar transistor and a junction field effect transistor (JFET) on a single semiconductor substrate (10) of a first conductivity type, comprising:
a JFET buried region (16) of a second connductivity type at a face of the semiconductor substrate;
a bipolar buried region (24) of the second conductivity type at the face and spaced from the JFET buried region;
a collector region (28) of the first conductivity type at the face and within the bipolar buried region;
an epitaxial semiconductor layer (38) of the second conductivity type on the face of the semiconductor substrate;
the JFET buried region and the collector region extending into the epitaxial layer;
a deep collector region (48) of the first conductivity type extending from an outer face of the epitaxial layer to the collector region;
a base region (58) of the first conductivity type at the face of the epitaxial layer over the collector region and spaced therefrom;
an emitter region (70), a JFET source region (74) and a JFET drain region (76) of the first conductivity type at the face of the epitaxial layer, the emitter region formed within the base region, the JFET source and drain regions formed over and spaced from the JFET buried region and laterally spaced from each other; and
a base contact region (84) and a gate contact region (88) of the second conductivity type at the face of the epitaxial layer, the base contact region formed within the base region and spaced from the emitter region, the gate contact region formed over the JFET buried region and spaced from the source and drain regions.

## Patentansprüche

1. Verfahren zum Herstellen eines vertikalen Bipolartransistors und eines Sperrschicht-Feldeffekttransistors (JFET) unter Verwendung eines einzigen Halbleitersubstrats (10) eines ersten Leitungstyps, enthaltend die Schritte:
Bilden einer vergrabenen JFET-Zone (16) eines zweiten Leitungstyps an einer Fläche des Halbleitersubstrats;
Bilden einer vergrabenen Bipolarzone (24) des zweiten Leitungstyps an der Fläche und in einem Abstand von der vergrabenen JFET-Zone;
Bilden einer Kollektorzone (28) des ersten Leitungstyps an der Fläche und innerhalb der vergrabenen Bipolarzone;
Bilden einer Halbleiter-Epitaxieschicht (38) des zweiten Leitungstyps auf der Fläche des Halbleitersubstrats;
Erweitern der vergrabenen JFET-Zone und der Kollektorzone in die Epitaxieschicht durch thermische Diffusion;
Bilden einer tiefen Kollektorzone (48) des ersten Leitungstyps, die sich von einer Außenfläche der Epitaxieschicht zur Kollektorzone erstreckt;
Bilden einer Basiszone (58) des ersten Leitungstyps an der Fläche der Epitaxieschicht über der Kollektorzone und in einem Abstand von dieser;
gleichzeitiges Bilden einer Emitterzone (70), einer JFET-Sourcezone (74) und einer JFET-Drainzone (76) des ersten Leitungstyps an der Fläche der Epitaxieschicht, wobei die Emitterzone innerhalb der Basiszone gebildet wird, wobei die JFET-Sourcezone und die JET-Drainzone über der vergrabenen JFET-Zone und in einem Abstand von dieser gebildet werden und in einem seitlichen Abstand voneinander gehalten werden; und gleichzeitiges Bilden einer Basis-Kontaktzone (84) und einer Gate-Kontaktzone (88) des zweiten Leitungstyps an der Fläche der Epitaxieschicht, wobei die Basis-Kontaktzone innerhalb der Basiszone und in einem Abstand von der Emitterzone gebildet wird und wobei die Gate-Kontaktzone über der vergrabenen JFET-Zone und in einem Abstand von der Source- und der Drainzone gebildet wird.

2. Verfahren nach Anspruch 1, bei welchem der erste Leitungstyp (p) ist.

3. Verfahren nach Anspruch 1 oder Anspruch 2, weiter enthaltend die Schritte:
Bilden wenigstens einer tiefen Sperrschicht-Isolationszone (36), für die der erste Leitungstyp vorgesehen ist, im Halbleitersubstrat, gleichzeitig mit dem Schritt des Bildens der Kollektorzone darin, wobei die tiefe Sperrschicht-Isolationszone zwischen der Kollektorzone und der vergrabenen JFET-Zone gebildet wird; und Bilden wenigstens einer flachen Sperrschicht-Isolationszone (46) des ersten Leitungstyps in der Epitaxieschicht über der tiefen Sperrschicht-Isolationszone, gleichzeitig mit dem Schritt des Bildens der tiefen Kollektorzone, so daß die flache Sperrschicht-Isolationszone und die tiefe Sperrschicht-Isolationszone miteinander verbunden werden.

4. Verfahren nach Anspruch 3, weiter enthaltend den Schritt:
Bilden einer Feldanpassungszone (62) mit einem Störstoff des zweiten Leitungstyps an der Fläche der Epitaxieschicht, die zwischen der Basiszone und der flachen Sperrschicht-Isolationszone anzuordnen ist.

5. Verfahren nach Anspruch 3 oder Anspruch 4, weiter enthaltend die Schritte:
gleichzeitig erfolgendes, nach oben gerichtetes Diffundieren eines Störstoffs aus der tiefen Sperrschicht-Isolationszone und aus der Kollektorzone in die Epitaxieschicht; und
gleichzeitig erfolgendes, nach unten gerichtetes Diffundieren eines Störstoffs aus der flachen Sperrschicht-Isolationszone und aus der tiefen Kollektorzone, so daß die tiefe Kollektorzone Kontakt zur Kollektorzone herstellt und die flache Sperrschicht-Isolationszone und die tiefe Sperrschicht-Isolationszone zusammenhängend werden.

6. Verfahren nach einem der Ansprüche 1 bis 4, weiter enthaltend den Schritt des so lange erfolgenden, nach unten gerichteten Diffundierens eines Störstoffs aus der tiefen Kollektorzone, bis diese und die Kollektorzone zusammenhängend werden.

7. Verfahren nach einem der vorhergehenden Ansprüche, weiter enthaltend den Schritt des Bildens einer ersten Oxidschicht (12) über einer Außenfläche des Halbleitersubstrats; und
das vor jedem der Schritte des Bildens der Kollektorzone, des Bildens der vergrabenen Bipolarzone bzw. des Bildens der vergrabenen JFET-Zone erfolgende Entfernen eines jeweiligen vorgegebenen Abschnitts der Oxidschicht für jeden der Schritte, so daß die Oxidschicht als eine Dotierungsmaske für den jeweiligen Schritt wirkt.

8. Verfahren nach einem der vorhergehenden Ansprüche, weiter enthaltend die Schritte:
Bilden einer Oxidschicht (40) auf einer Außenfläche der Epitaxieschicht nach dem Schritt des Bildens der Halbleiter-Epitaxieschicht; und
Entfernen eines jeweiligen Abschnitts der Oxidschicht vor jedem der Schritte des Bildens der tiefen Kollektorzone, des Bildens der Basiszone und des Bildens der Emitterzone, damit die Oxidschicht als jeweilige Dotierungsmaske für den jeweiligen Schritt wirkt.

9. Verfahren nach einem der vorhergehenden Ansprüche, weiter enthaltend die Schritte:
Bilden einer Gate-Isolatorschicht (92) über der Epitaxieschicht über einer Kanalzone von dieser zwischen der Sourcezone und der Drainzone, so daß sich diese seitlich zur Gate-Kontaktzone erstreckt, nach dem Schritt des gleichzeitigen Bildens der Basis-Kontaktzone und der Gate-Kontaktzone;
Implantieren eines Störstoffs des zweiten Leitungstyps durch die Gate-Isolatorschicht zur Bildung einer oberen Gate-Elektrode, die sich von der Gate-Kontaktzone zur Source- und zur Drainzone erstreckt; und
Implantieren eines Störstoffs des ersten Leitungstyps durch die Gate-Isolatorschicht zum Dotieren der Kanalzone.

10. Verfahren nach einem der vorhergehenden Ansprüche, weiter enthaltend die Schritte:
Bilden einer tiefen Sperrschicht-Isolationszone (121) des ersten Leitungstyps in dem Substrat, gleichzeitig mit dem Schritt des Bildens der Kollektorzone; und
Bilden eines Kondensators über der Sperrschicht-Isolationszone.

11. Verfahren nach Anspruch 10, weiter enthaltend den Schritt des Bildens einer flachen Sperrschicht-Isolationszone (46) des ersten Leitungstyps in der Epitaxieschicht für den Kondensator, gleichzeitig mit dem Schritt des Bildens der tiefen Kollektorzone, so daß die tiefe Sperrschicht-Isolationszone und die flache Sperrschicht-Isolationszone zu einer zusammenhängenden Sperrschicht-Isolationszone werden.

12. Verfahren nach Anspruch 11, weiter enthaltend die Schritte:
Bilden einer Oxidschicht (40) auf der Epitaxieschicht über der Sperrschicht-Isolationszone; und
Bilden eines Kondensators auf der Oxidschicht über der Sperrschicht-Isolationszone.

13. Verfahren nach einem der vorhergehenden Ansprüche, bei welchem ein Kondensator in einem Kondensatorbereich des Halbleitersubstrats gebildet wird und das Verfahren weiter die folgenden Schritte beinhaltet:
Bilden einer Kondensatorelektrode (124) aus polykristallinem Silicium, die isoliert in einem Abstand über der Epitaxieschicht im Kondensatorbereich anzuordnen ist; und Dotieren der Elektrode aus polykristallinem Silicium, so daß diese stark leitfähig ist, gleichzeitig mit dem Schritt des gleichzeitigen Bildens der Basis-Kontaktzone und der Gate-Kontaktzone.

14. Verfahren nach einem der vorhergehenden Ansprüche, weiter enthaltend den Schritt des Bildens einer Kontaktzone (86) des zweiten Leitungstyps zu der vergrabenen Bipolarzone an der Außenfläche der Epitaxieschicht über der vergrabenen Bipolarzone und in einem Abstand von der tiefen Kollektorzone, gleichzeitig mit dem Schritt des gleichzeitigen Bildens der Basis-Kontaktzone und der Gate-Kontaktzone.

15. Integrierte Schaltung mit einem vertikalen Bipolartransistor und einem Sperrschicht-Feldeffekttransistor (JFET) auf einem einzigen Halbleitersubstrat (10) eines ersten Leitungstyps, enthaltend:
eine vergrabene JFET-Zone (16) eines zweiten Leitungstyps an einer Fläche des Halbleitersubstrats;
eine vergrabene Bipolarzone (24) des zweiten Leitungstyps an der Fläche in einem Abstand von der vergrabenen JFET-Zone;
eine Kollektorzone (28) des ersten Leitungstyps an der Fläche und innerhalb der vergrabenen Bipolarzone;
eine Halbleiter-Epitaxieschicht (38) des zweiten Leitungstyps auf der Fläche des Halbleitersubstrats;
die vergrabenen JFET-Zone und die Kollektorzone, die sich in die Epitaxieschicht hinein erstrecken;
eine tiefe Kollektorzone (48) des ersten Leitungstyps, die sich von einer Außenfläche der Epitaxieschicht zur Kollektorzone erstreckt;
eine Basiszone (58) des ersten Leitungstyps an der Fläche der Epitaxieschicht über der Kollektorzone und in einem Abstand von dieser;
eine Emitterzone (70), eine JFET-Sourcezone (74) und eine JFET-Drainzone (76) des ersten Leitungstyps an der Fläche der Epitaxieschicht, wobei die Emitterzone innerhalb der Basiszone gebildet ist, wobei die JFET-Sourcezone und die JFET-Drainzone über der vergrabenen JFET-Zone und in einem Abstand von dieser gebildet sind und in einem seitlichen Abstand voneinander angeordnet sind; und
eine Basis-Kontaktzone (84) und eine Gate-Kontaktzone (88) des zweiten Leitungstyps an der Fläche der Epitaxieschicht, wobei die Basis-Kontaktzone innerhalb der Basiszone gebildet ist und sich in einem Abstand zur Emitterzone befindet und wobei die Gate-Kontaktzone über der vergrabenen JFET-Zone gebildet ist und sich in einem Abstand von der Source- und der Drainzone befindet.

## Revendications

1. Procédé de fabrication d'un transistor bipolaire vertical et d'un transistor au niveau effet de champ au niveau de jonction (JFET) à l'aide d'un substrat semi-conducteur unique (10) d'un premier type de conductivité, comprenant les étapes suivantes :
la formation d'une région enfouie JFET (16) d'un second type de conductivité au niveau d'une face du substrat semi-conducteur,
la formation d'une région bipolaire enfouie (24) du second type de conductivité au niveau de la face et à distance de la région enfouie JFET,
la formation d'une région de collecteur (28) du premier type de conductivité au niveau de la face et dans la région bipolaire enfouie,
la formation d'une couche semi-conductrice épitaxiale (38) du second type de conductivité sur la face du substrat semi-conducteur,
l'extension de la région enfouie JFET et de la région de collecteur dans la couche épitaxiale par diffusion thermique,
la formation d'une région profonde de collecteur (48) du premier type de conductivité afin qu'elle s'étende d'une face externe de la couche épitaxiale à la région de collecteur,
la formation d'une région de base (58) du premier type de conductivité au niveau de la face de la couche épitaxiale sur la région de collecteur et à distance de celle-ci,
la formation simultanée d'une région d'émetteur (70), d'une région de source JFET (74) et d'une région de drain JFET (76) du premier type de conductivité au niveau de la face de la couche épitaxiale, la région d'émetteur étant formée dans la région de base, les régions de source et de drain JFET étant formées au-dessus et à distance de la région enfouie JFET et étant espacées latéralement l'une de l'autre, et la formation simultanée d'une région (84) de contact de base et d'une région (88) de contact de grille du second type de conductivité au niveau de la face de la couche épitaxiale, la région de contact de base étant formée dans la région de base et à distance de la région d'émetteur, la région de contact de grille étant formée au-dessus de la région enfouie JFET et à distance des régions de source et de drain.

2. Procédé selon la revendication 1, dans lequel le premier type de conductivité est (p).

3. Procédé selon la revendication 1 ou 2, comprenant en outre les étapes suivantes :
la formation d'au moins une région profonde d'isolement à jonction (36) destinée à être du premier type de conductivité dans le substrat semi-conducteur en même temps que l'étape de formation de la région de collecteur dans cette région, la région profonde d'isolement à jonction étant formée entre la région de collecteur et la région enfouie JFET, et
la formation d'au moins une région peu profonde d'isolement de jonction (46) du premier type de conductivité dans la couche épitaxiale au-dessus de la région profonde d'isolement de jonction en même temps que l'étape de formation de la région profonde de collecteur, afin que la région peu profonde d'isolement de jonction et la région profonde d'isolement de jonction soient jointes.

4. Procédé selon la revendication 3, comprenant en outre l'étape suivante :
la formation d'une région d'ajustement de champ (62) à l'aide d'une matière de dopage du second type de conductivité au niveau de la face de la couche épitaxiale afin qu'elle soit placée entre la région de base et la région peu profonde d'isolement de jonction.

5. Procédé selon la revendication 3 ou 4, comprenant en outre les étapes suivantes :
la diffusion simultanée d'une matière de dopage vers le haut depuis la région profonde d'isolement de jonction et depuis la région de collecteur dans la couche épitaxiale, et
simultanément la diffusion vers le bas d'une matière de dopage de la région peu profonde d'isolement de jonction et de la région de collecteur profonde afin que la région profonde de collecteur soit au contact de la région de collecteur et que les régions peu profonde et profonde d'isolement de jonction deviennent continues.

6. Procédé selon l'une quelconque des revendications 1 à 4, comprenant en outre une étape de diffusion vers le bas d'une matière de dopage provenant de la région profonde de collecteur jusqu'à ce que la région profonde de collecteur soit continue avec la région de collecteur.

7. Procédé selon l'une quelconque des revendications précédentes, comprenant en outre une étape de formation d'une première couche d'oxyde (12) sur une face externe du substrat semi-conducteur, et
avant chacune des étapes respectives de formation de la région de collecteur, de formation de la région bipolaire enfouie et de formation de la région enfouie JFET, l'enlèvement, pour chaque étape respective, d'une partie respective prédéterminée de la couche d'oxyde afin que la couche d'oxyde joue le rôle d'un masque de dopage pour l'étape respective.

8. Procédé selon l'une quelconque des revendications précédentes, comprenant en outre les étapes suivantes : après l'étape de formation de la couche semi-conductrice épitaxiale, la formation d'une couche d'oxyde (40) sur une face externe de la couche épitaxiale, et
avant chacune des étapes respectives de formation de la région profonde de collecteur, de formation de la région de base et de formation de la région d'émetteur, l'enlèvement d'une partie respective de la couche d'oxyde afin qu'elle agisse comme masque respectif de matière de dopage de l'étape respective.

9. Procédé selon l'une quelconque des revendications précédentes, comprenant en outre les étapes suivantes : après l'étape de formation simultanée de la région de contact de base et de la région de contact de grille, la formation d'une couche d'isolement de grille (92) sur la couche épitaxiale au-dessus d'une région de canal de celle-ci entre la région de source et de la région de drain, afin qu'elle s'étende latéralement jusqu'à la région de contact de grille,
l'implantation d'une matière de dopage du second type de conductivité à travers la couche d'isolement de grille pour la formation d'une grille supérieure s'étendant depuis la région de contact de grille vers les régions de source et de drain, et
l'implantation d'une matière de dopage du premier type de conductivité à travers la couche d'isolement de grille pour le dopage de la région de canal.

10. Procédé selon l'une quelconque des revendications précédentes, comprenant en outre les étapes suivantes :
la formation d'une région profonde d'isolement de jonction (121) du premier type de conductivité dans le substrat en même temps que l'étape de formation de la région de collecteur, et la formation d'un condensateur au-dessus de la région d'isolement de jonction.

11. Procédé selon la revendication 10, comprenant en outre l'étape de formation d'une région peu profonde d'isolement de jonction (46) du premier type de conductivité dans la couche épitaxiale pour le condensateur en même temps que l'étape de formation de la région profonde de collecteur, si bien que la région profonde d'isolement de jonction et la région peu profonde d'isolement de jonction deviennent une région continue d'isolement de jonction.

12. Procédé selon la revendication 11, comprenant en outre les étapes suivantes :
la formation d'une couche d'oxyde (40) sur la couche épitaxiale au-dessus de la région d'isolement de jonction, et
la formation d'un condensateur sur la couche d'oxyde au-dessus de la région d'isolement de jonction.

13. Procédé selon l'une quelconque des revendications précédentes, dans lequel un condensateur est formé dans une région de condensateur du substrat semi-conducteur, le procédé comprenant en outre les étapes suivantes :
la formation d'une électrode (124) de condensateur de silicium polycristallin destinée à être maintenue à distance au-dessus de la couche épitaxiale de manière isolante dans la zone du condensateur, et le dopage de l'électrode de silicium polycristallin afin qu'elle soit très conductrice, en même temps que l'étape de formation simultanée de la région de contact de base et de la région de contact de grille.

14. Procédé selon l'une quelconque des revendications précédentes, comprenant en outre l'étape de formation d'une région (86) de contact avec la région bipolaire enfouie du second type de conductivité au niveau de la face externe de la couche épitaxiale au-dessus de la région bipolaire enfouie et à distance de la région profonde de collecteur, en même temps que l'étape de formation simultanée de la région de contact de base et de la région de contact de grille.

15. Circuit intégré comprenant un transistor bipolaire vertical et un transistor à effet de champ à jonction (JFET) sur un seul substrat semi-conducteur (10) d'un premier type de conductivité, comprenant :
une région enfouie JFET (16) d'un second type de conductivité au niveau d'une face du substrat semi-conducteur,
une région bipolaire enfouie (24) du second type de conductivité au niveau de la face de la région enfouie JFET et à distance de celle-ci,
une région de collecteur (28) du premier type de conductivité au niveau de la face et dans la région bipolaire enfouie,
une couche semi-conductrice épitaxiale (38) du second type de conductivité au niveau de la face du substrat semi-conducteur,
la région enfouie JFET et la région de collecteur s'étendant dans la couche épitaxiale,
une région profonde de collecteur (48) du premier type de conductivité s'étendant d'une face externe de la couche épitaxiale à la région de collecteur,
une région de base (58) du premier type de conductivité au niveau de la face de la couche épitaxiale au-dessus de la région de collecteur et à distance de celle-ci,
une région d'émetteur (70), une région de source JFET (74) et une région de drain JFET (76) du premier type de conductivité au niveau de la face de la couche épitaxiale, la région d'émetteur étant formée dans la région de base, les régions de source et de drain JFET étant formées au-dessus de la région enfouie JFET et à distance de celle-ci et étant espacées latéralement l'une par rapport à l'autre, et
une région (84) de contact de base et une région (88) de contact de grille du second type de conductivité au niveau de la face de la couche épitaxiale, la région de contact de base étant formée dans la région de base et à distance de la région d'émetteur, la région de contact de grille étant formée au-dessus de la région enfouie JFET et étant distante des régions de source et de drain.
